(19) Europäisches Patentamt / European Patent Office / Office européen des brevets

(11) **EP 4 343 859 A1**

(12) **EUROPEAN PATENT APPLICATION**

(43) Date of publication:
**27.03.2024 Bulletin 2024/13**

(21) Application number: **23186621.1**

(22) Date of filing: **20.07.2023**

(51) International Patent Classification (IPC):
**H01L 31/107** *(2006.01)*     **H01L 31/024** *(2014.01)*
**H01L 31/0232** *(2014.01)*     **H01L 31/02** *(2006.01)*
**G02B 6/42** *(2006.01)*

(52) Cooperative Patent Classification (CPC):
**H01L 31/024; G01M 11/31; H01L 31/02005;**
**H01L 31/02325; H01L 31/107;** G02B 6/4204;
G02B 6/4266; G02B 6/4292

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **26.09.2022 EP 22306420**

(71) Applicant: **Viavi Solutions Inc.**
**Chandler, AZ 85286 (US)**

(72) Inventors:
• **VERDUN, Michael**
  **42170 Saint-Just-Saint-Rambert (FR)**
• **JACQUY, Pierrick**
  **69003 Lyon (FR)**

(74) Representative: **Murgitroyd & Company**
**165-169 Scotland Street**
**Glasgow G5 8PL (GB)**

(54) **PHOTODIODE MODULES WITH REDUCED RECOVERY TIMES**

(57)     In some examples, a photodiode module may include a photodiode chip, a submount located adjacent to the photodiode chip, and a heating element to heat the photodiode chip. By increasing the temperature of the photodiode chip through use of the heating element, the cutoff wavelength of the photodiode chip may be increased, which may also increase the quantum efficiency and the recovery time of the photodiode chip.

*FIG. 2A*

*FIG. 2B*

**EP 4 343 859 A1**

**Description**

BACKGROUND

An avalanche photodiode (APD), which may also be referenced as a semiconductor photodiode detector, converts light into electricity by utilizing the photoelectric effect. APDs often include a relatively high sensitivity and a relatively high internal gain. Additionally, APDs are often used in fiber optic communication systems as photodetectors.

SUMMARY

According to an aspect of the present disclosure there is provided a photodiode module in accordance with the accompanying claims.

According to a further aspect of the present disclosure there is provided a photodiode module comprising: a photodiode chip; and a heating element to heat the photodiode chip to reduce a recovery time of the photodiode chip.

The photodiode module may further comprise: a fiber pigtailed package enclosing the photodiode chip. The heating element may be positioned on a submount located adjacent to the photodiode chip. The photodiode module may further comprise: a first heating element contact; and a second heating element contact, wherein the first heating element contact and the second heating element contact are in electrical contact with the heating element and are positioned on the submount. The photodiode module may further comprise: an electrical isolator positioned between the heating element and the photodiode chip. The heating element may be part of the photodiode chip. The heating element may be to cause a decrease in recovery time of the photodiode chip. The photodiode module may further comprise: a thermistor positioned to detect a temperature of the heating element, the thermistor to send temperature measurements to a controller and the controller to control, by at least one hardware processor, the temperature of the heating element based on the temperature measurements.

According to a further aspect of the present disclosure there is provided a photodiode module comprising: an avalanche photodiode chip; and a heating element to heat the avalanche photodiode chip to cause a recovery time of the avalanche photodiode chip to be reduced.

The photodiode module may comprise: a fiber pigtailed package enclosing the avalanche photodiode chip. The photodiode module may further comprising: a submount located adjacent to the avalanche photodiode chip, wherein the heating element is positioned on the submount, adjacent to the avalanche photodiode chip. The photodiode module may further comprise: a first heating element contact; and a second heating element contact, wherein the first heating element contact and the second heating element contact are in electrical contact with the heating element and are positioned on the submount. The photodiode module may further comprise: an electrical isolator positioned between the heating element and the avalanche photodiode chip. The photodiode module may further comprise: a thermistor positioned to detect a temperature of the heating element, the thermistor to send temperature measurements to a controller and the controller to control the temperature of the heating element based on the temperature measurements.

According to a still further aspect of the present disclosure there is provided a photodiode module comprising: a photodiode chip; a heating element to heat the photodiode chip; a submount to support the photodiode chip; and a fiber pigtailed package enclosing the photodiode chip and the submount.

The heating element may be positioned between a portion of the photodiode chip and a portion of the submount. The photodiode module may further comprise: an electrical isolator positioned between the heating element and the photodiode chip. The photodiode module may further comprise: a first heating element contact; and a second heating element contact, wherein the first heating element contact and the second heating element contact are in electrical contact with the heating element and are positioned on the submount. The heating element may be to heat the photodiode chip to cause a reduction in recovery time of the photodiode chip. The photodiode module may further comprise: a thermistor positioned to detect a temperature of the heating element, the thermistor to send temperature measurements to a controller and the controller to control, by at least one hardware processor, the temperature of the heating element based on the temperature measurements.

BRIEF DESCRIPTION OF DRAWINGS

Features of the present disclosure are illustrated by way of example and not limited in the following figure(s), in which like numerals indicate like elements, in which:

Figure 1 illustrates a cross-sectional diagram of a conventional avalanche photodiode (APD);

Figure 2A illustrates a diagram of a photodiode module, in accordance with an example of the present disclosure;

Figure 2B illustrates a diagram of a photodiode chip, in accordance with an example of the present disclosure;

Figure 3A shows a diagram of a graph that shows the cutoff wavelength as a function of temperature of a photodiode chip, e.g., an indium gallium arsenide (InGaAs) APD, in accordance with an example of the present disclosure;

Figure 3B shows a diagram of a graph that shows the quantum efficiency as a function of wavelength for different temperatures, in accordance with an example of the present disclosure;

Figure 4 shows a diagram of a photodiode module, in accordance with an example of the present disclosure; and

Figure 5 illustrates a computer system, according to an example of the present disclosure.

DETAILED DESCRIPTION

For simplicity and illustrative purposes, the present disclosure is described by referring mainly to examples. In the following description, numerous specific details are set forth in order to provide a thorough understanding of the present disclosure. It will be readily apparent however, that the present disclosure may be practiced without limitation to these specific details. In other instances, some methods and structures have not been described in detail so as not to unnecessarily obscure the present disclosure.

Throughout the present disclosure, the terms "a" and "an" are intended to denote at least one of a particular element. As used herein, the term "includes" means includes but not limited to, the term "including" means including but not limited to. The term "based on" means based at least in part on. The term "optical fiber" may be generalized to an optical waveguide of any type.

An optical time-domain reflectometer (OTDR) device is an optoelectronic instrument used to characterize an optical fiber. An OTDR device injects a series of optical pulses into an optical fiber under test through a wavelength division multiplexing (WDM) component in order to test and monitor a network. Based on the injected optical pulses, the OTDR device may extract, from the same end of the optical fiber in which the optical pulses are injected, light that is scattered or reflected back from points along the optical fiber. The scattered or reflected light that is gathered back is used to characterize the optical fiber. For example, the scattered or reflected light that is gathered back is used to detect, locate, and measure events at any location of the optical fiber. The events may include faults at any location of the optical fiber. Other types of features that the OTDR device may measure include attenuation uniformity and attenuation rate, segment length, bends, fiber end, and location and insertion loss of connectors, splices, or any other optical components such as splitters or multiplexers.

In reflectometry, low levels of light (e.g., Rayleigh scattering) may need to be adequately measured immediately after occurrence of events such as Fresnel reflections or splitters on an optical probe pulse along an optical fiber under test. The light may need to be measured immediately after the occurrence of the events to avoid too long of a "dead zone," which is one of the main specifications of an OTDR device. In addition, because of the low level of the Rayleigh scattering, a high gain and low noise avalanche photodiode (APD), e.g., an APD with high sensitivity, is often needed to adequately measure the light.

In many instances, the wavelengths of interest are mainly located in the short wavelength infrared range (typically between around 1300 nm and around 1650 nm). Thus, the absorption region of the semiconductor of the APD may need to have a small energy bandgap, e.g., a wavelength cutoff higher than around 1650 nm. By way of particular example, indium gallium arsenide (InGaAs) is a semiconductor used as an absorption region for APDs, which has a relatively small energy bandgap. As a result, the use of an InGaAs semiconductor in an APD may lead to a poor level of noise. In many instances, heterojunctions and localized p-doped regions are used to provide high levels of sensitivity.

A high bandgap energy p-doped semiconductor with a smaller area than the absorption region area is defined as the active area of the semi-conductor structure (the high electric field area). Particularly this helps to have no electric field at the edge of the InGaAs region where defects in the semiconductor could lead to noise if localized in the high electric field region.

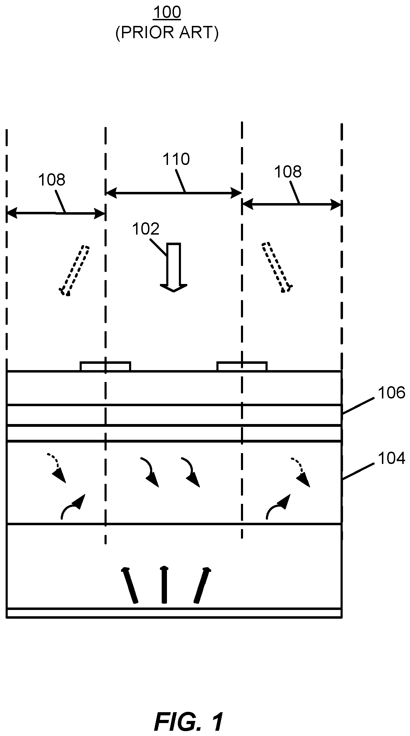

A drawback of these low noise structures is that they can lead to a relatively long recovery time. To illustrate the relatively long recovery time of certain APD structures, reference is made to Figure 1, which shows a cross-sectional diagram of a conventional APD 100. The APD 100 in Figure 1 shows the principle of the absorption of photons 102 in a front side illuminated InGaAs APD semiconductor structure. As shown, photons 102 are absorbed in the active absorption region 104, which may be made of InGaAs, and dissociated into electron and hole carriers. Those last carriers are multiplied in the multiplication region 106, which may be made of indium phosphide (InP), to give rise to an internal gain. In the example of Figure 1, the active absorption region 104 is delimited by a localized p-doped region (so-called planar structure).

The recovery time T_total of the APD shown in Figure 1 generally comes from three main time responses T_BW, T_LEF, and T_NDA as denoted by the following equation:

$$\text{Equation (1): } T\_total = T\_BW + T\_LEF + T\_NDA.$$

T_BW is an intrinsic time response of the APD 100 and may mainly be related to the bandwidth of the APD 100. This time response may be made to be negligible compared to the other two time responses by selecting an APD 100 with a sufficiently high bandwidth, e.g., a few GHz.

T_LEF is a time response of the photons that are directly absorbed in low electric field areas 108 (or at the edge of high electric field area 110). This time response may be important for a large beam compared to the high electric field area 110 or for beams with optical aberrations.

T_NDA is a time response of the photons that go through the high electric field area 110 but are not directly absorbed. For example, an InGaAs APD 100 may have a typical absorption efficiency of about 85% at 1550 nm and thus 15% of the photons are not directly absorbed. Instead, those photons are reflected or backscattered by the backside of the APD 100 to partly go into the low electric field areas 108.

Disclosed herein are photodiode modules that include photodiode chips, e.g., APDs, having improved or reduced recovery time. Particularly, for instance, the photodiode modules disclosed herein may include structures that reduce the T_NDA response time of the photodiode chips. The photodiode modules disclosed herein may reduce the T_NDA response time through inclusion of heating elements that are to heat the photodiode chips during usage of the photodiode chips. Particularly, the heating elements may increase the temperatures of the photodiode chips, which may allow the quantum efficiency of the photodiode chips to increase at a given wavelength, especially near an ambient temperature wavelength cutoff, which may be around 1650 nm for InGaAs APDs. The quantum efficiency may be increased because the quantum efficiency increases as a function of wavelength. In addition, the increase in the quantum efficiency reduces or improves the recovery times of the photodiode chips.

The heating elements may be positioned between the photodiode chips and submounts of the photodiode modules. In some examples, the heating elements are positioned on the submounts, while in other examples, the heating elements are formed as part of the photodiode chips. In some examples, the photodiode module includes a fiber pigtailed package that encloses the photodiode chips and the submounts.

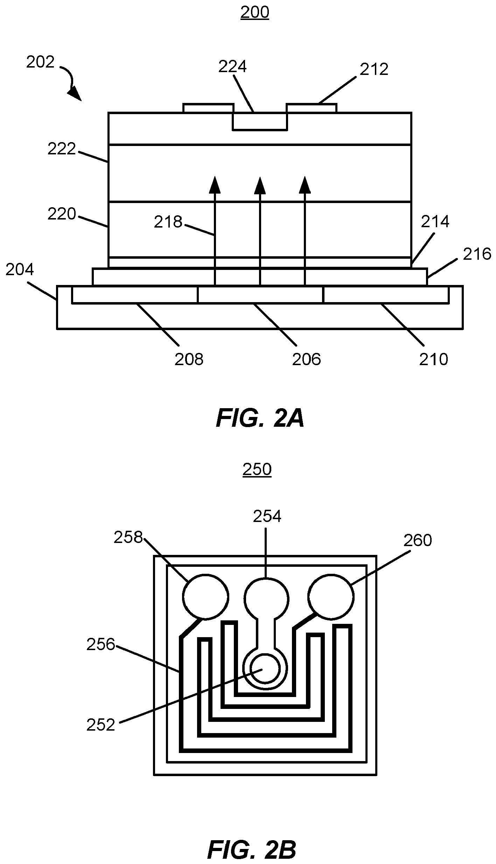

Reference is now made to Figure 2A, which illustrates a diagram of a photodiode module 200, in accordance with an example of the present disclosure. The photodiode module 200 is depicted in Figure 2A as including a photodiode chip 202, a submount 204, and a heating element 206. The photodiode chip 202 may be similar to the APD 100 depicted in Figure 1 and may thus include the elements described above with respect to Figure 1. The submount 204 may be formed of a thermally non-conductive material, such as a ceramic material like alumina and/or the like. The photodiode chip 202 may be adhered to the submount 204 through use of an adhesive, welding, and/or the like, or may be mounted to the submount 204 via a mechanical fastener.

As discussed herein, the heating element 206 is positioned with respect to the photodiode chip 202 to increase a temperature of at least a portion of the photodiode chip 202. Particularly, the heating element 206 is to increase a temperature of the photodiode chip 202, or a portion of the photodiode chip 202, to a temperature that increases recovery time of the photodiode chip 202. In other words, the heating element 206 is to increase the temperature of the photodiode chip 202 to a sufficient level to cause a quantum efficiency of the photodiode chip 202 to be increased above a cutoff wavelength of the photodiode chip 202.

In some examples, and as shown in Figure 2A, the heating element 206 is positioned between the photodiode chip 202 and the submount 204. In some examples, the heating element 206 is formed within or on the submount 204 at an interface location adjacent to a bottom surface of the photodiode chip 202. In other examples, the heating element 206 is formed within or on the photodiode chip 202 at an interface location adjacent to a top surface of the submount 204. In any of these examples, the heating element 206 is formed of any suitable material that may become heated through receipt of electrical energy, e.g., a material that converts electrical energy into heat. For instance, the heating element may be formed of a metallic material, tantalum nitride (TaN), or the like.

As shown in Figure 2A, the heating element 206 is in electrical contact with a first heating element contact 208 and a second heating element contact 210. The first heating element contact 208 and the second heating element contact 210 are shown to be in electrical contact with an electrical energy source (not shown) such that electrical energy may be conducted through the heating element 206 via the first heating element contact 208 and the second heating element contact 210. The heating element 206 converts the electrical energy into heat such that heat from the heating element 206 increases a temperature of the photodiode chip 202 (or a portion of the photodiode chip 202).

As also shown in Figure 2A, the photodiode chip 202 includes an anode 212 and a cathode 214, where the cathode 214 is near the heating element 206. In some examples, an electrical isolator 216 may be positioned between the heating element 206 and the cathode 214. The electrical isolator 216 blocks or reduces the flow of electricity between the heating element 206 and the cathode 214. However, the electrical isolator 216 may enable heat to flow through the electrical isolator 216 from the heating element 206 to the cathode 214. The electrical isolator 216 may be formed either by a thin dielectric film or by a submount. In some examples, the thin dielectric film may be a silicon nitride (SiNx) or a silicon dioxide (SiO$_2$) layer. The submount 204 may be made of any suitable material that is thermally conductive while also being electrically insulative. Examples of such suitable materials include aluminum nitride, beryllium oxide, diamond, sapphire, and/or the like.

As shown in Figure 2A, heat, which is represented by the arrows 218, that is generated in the heating element 206, flows through the electrical isolator 216 and into the photodiode chip 202. The heat 218 may be conducted through the electrical isolator 216 into an active absorption region 220 of the photodiode chip 202. The heat 218 may also be conducted through the active absorption region 220 and into the multiplication region 222 of the photodiode chip 202. In some instances, the heat 218 may further be conducted through the multiplication region 222 and to a p-doped area 224 of the photodiode chip 202.

According to examples, the heating element 206 has a relatively small form factor, e.g., is relatively smaller in length and width than the photodiode chip 202. In some examples, the relatively small size of the heating element 206 enables the heating element 206 to heat the photodiode chip 202 without significantly heating a fiber or an electronic board near the photodiode chip 202.

As shown in Figure 2A, the p-doped area 224 is relatively smaller than the active absorption region 220. According to examples, the photodiode chip 202 is a front side illuminated avalanche photodiode chip having a heterojunction structure with a high bandgap energy p-doped semiconductor area 224 that is smaller than the absorption region 220.

According to examples, instead of being formed or included in the submount 204, the heating element 206 may be formed or otherwise included in the photodiode chip 202. For instance, the heating element 206 may be formed on the top side of the photodiode chip 250 as shown in Figure 2B. Particularly, Figure 2B shows a diagram of a photodiode chip 250, according to an example of the present disclosure.

As shown in Figure 2B, the photodiode chip 250 includes an active area 252 of the photodiode chip 250. The active area 252 may include, for instance, the elements 220-224 of the photodiode module 200 depicted in Figure 2A. The photodiode chip 250 is also depicted as including an anode bonding pad 254 on which an anode, e.g., anode 212, is to be bonded. The photodiode chip 250 is further depicted as including a heating element 256 in the form of a coiled wire that is positioned adjacent to the active area 252. The heating element 256 is depicted as being electrically connected to a first heating element bonding pad 258 and a second heating element bonding pad 260. The first heating element bonding pad 258 may be equivalent to the first heating element contact 208 and the second heating element bonding pad 260 may be equivalent to the second heating element contact 210.

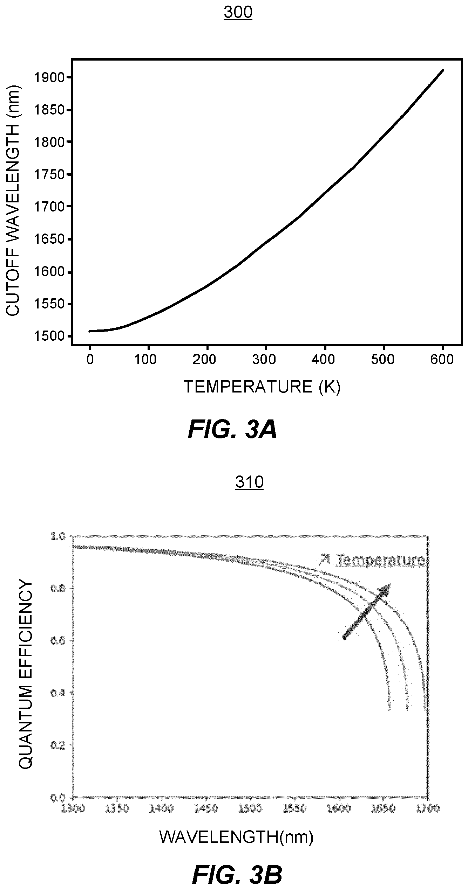

With reference now to Figure 3A, there is shown a diagram of a graph 300 that shows the cutoff wavelength as a function of temperature of a photodiode chip, e.g., an InGaAs APD, according to an example of the present disclosure. The cutoff wavelength may be defined as the wavelength where an incoming light has nearly enough energy to free an electron. In other words, the cutoff wavelength may be the wavelength at which all of a photon's energy goes into overcoming the work friction barrier. As shown in the graph 300, the cutoff wavelength increases with an increase in temperature. In this regard, by increasing the temperature of the photodiode chip 202 through use of the heating element 206, the cutoff wavelength of the photodiode chip 202 may be increased.

With reference now to Figure 3B, there is shown a diagram of a graph 310 that shows the quantum efficiency as a function of wavelength for different temperatures, in accordance with an example of the present disclosure. The quantum efficiency may be defined as the ratio of the number photoelectrons released in a photoelectric process to the number of radiation quanta absorbed. As shown in the graph 310, the quantum efficiency of the wavelengths increases as temperature increases. In this regard, by increasing the temperature of the photodiode chip 202 through use of the heating element 206, which increases the cutoff wavelength, the quantum efficiency of the photodiode chip 202 may also be increased. The Increase in the quantum efficiency of the photodiode chip 202 may also improve the recovery time of the photodiode chip 202.

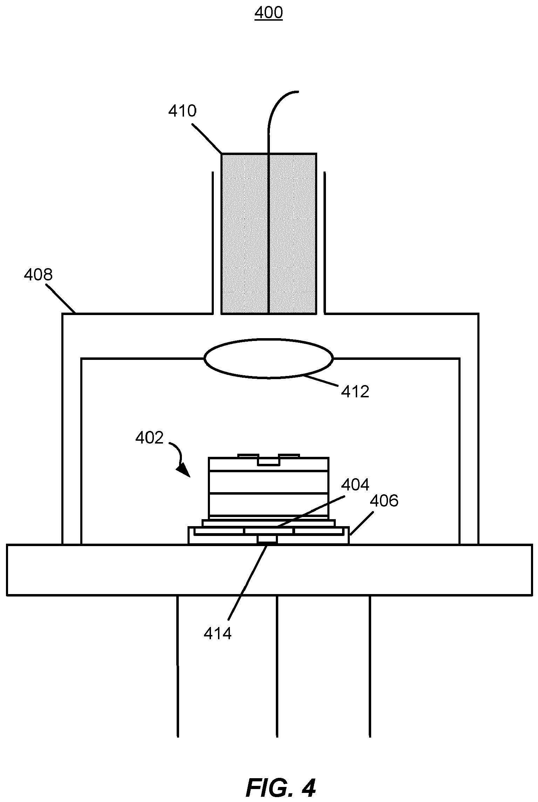

Reference is now made to Figure 4, which shows a diagram of a photodiode module 400, in accordance with an example of the present disclosure. As shown, the photodiode module 400 includes a photodiode chip 402, which, in some examples, is an avalanche photodiode chip. The photodiode module 400 also includes a heating element 404 and a submount 406. The photodiode chip 402, the heating element 404, and the submount 406 are depicted as being enclosed within a fiber pigtailed package 408. For instance, the fiber pigtailed package 408 is a TO-can pigtailed package.

As shown, the fiber pigtailed package 408 is depicted as positioning an end of a fiber 410 near a front side of the photodiode chip 402. The fiber pigtailed package 408 is also depicted as including a lens 412 or other optical device that may direct light from the fiber 410 and onto the front side of the photodiode chip 402. According to examples, the fiber 410, which may be an optical fiber, may be butt-coupled to the photodiode chip 402.

In some examples, the photodiode module 400 may include a thermistor 414 that is positioned to detect a temperature of the heating element 404. In Figure 4, the thermistor 414 is depicted as being positioned beneath the heating element 404 in the submount 406. In other examples, the thermistor 414 may be positioned at other locations.

In any of these examples, the thermistor 414 may send temperature measurements to a controller (not shown) of the heating element 404. In addition, the controller may control, by at least one hardware processor, the temperature of the heating element 404 based on the temperature measurements. For instance, the controller may be an external proportional, integral, derivative (PID) temperature controller.

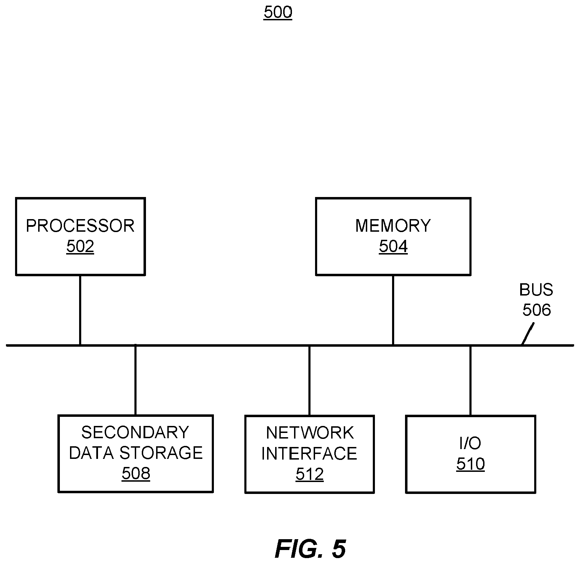

Reference is now made to Figure 5, which shows a computer system 500 that may be used with the examples described herein. The computer system may represent a generic platform that includes components that may be in a server or another computer system. The computer system 500 may be used as part of a platform for the photodiode module 200, the photodiode chip 250, and the photodiode module 400. The computer system 500 may execute, by a processor 502 (e.g., a single or multiple processors) or other hardware processing circuit, the methods, functions and other processes described herein. These methods, functions and other processes may be embodied as machine readable instructions stored on a computer readable medium (e.g., memory 504), which may be non-transitory, such as hardware storage devices (e.g., RAM (random access memory), ROM (read only memory), EPROM (erasable, programmable ROM), EEPROM (electrically erasable, programmable ROM), hard drives, and flash memory).

The computer system 500 may include a processor 502 that may implement or execute machine readable instructions performing some or all of the methods, functions and other processes described herein. Commands and data from the processor 502 may be communicated over a communication bus 506. The computer system 500 may also include a main memory 504, such as a random access memory (RAM), where the machine readable instructions and data for the processor 502 may reside during runtime, and a secondary data storage 508, which may be non-volatile and stores machine readable instructions and data. The memory 504 and data storage 508 are examples of computer readable mediums. The memory 504 may include machine readable instructions to control activation of the heating element 206, 256 during runtime and executed by the processor 502.

The computer system 500 may include an I/O device 510, such as a keyboard, a mouse, a display, etc. The computer system 500 may also include a network interface 512 for connecting to a network. Other known electronic components may be added or substituted in the computer system.

The processor 502 may be designated as a hardware processor. The processor 502 may execute operations associated with various components of an OTDR device.

What has been described and illustrated herein is an example along with some of its variations. The terms, descriptions and figures used herein are set forth by way of illustration only and are not meant as limitations. Many variations are possible within the spirit and scope of the subject matter, which is intended to be defined by the following claims -- and their equivalents -- in which all terms are meant in their broadest reasonable sense unless otherwise indicated.

**Claims**

1. A photodiode module comprising:

   a photodiode chip; and
   a heating element to heat the photodiode chip.

2. The photodiode module of claim 1, wherein the heating element is to heat the photodiode chip to reduce a recovery time of the photodiode chip.

3. The photodiode module of claim 1, wherein the photodiode chip is an avalanche photodiode chip.

4. The photodiode module of either claim 1 or claim 2, further comprising:
   a fiber pigtailed package enclosing the photodiode chip.

5. The photodiode module of claim 1, wherein the heating element is positioned on a submount located adjacent to the photodiode chip.

6. The photodiode module of claim 5, further comprising:

   a first heating element contact; and
   a second heating element contact, wherein the first heating element contact and the second heating element contact are in electrical contact with the heating element and are positioned on the submount.

7. The photodiode module of claim 6, further comprising:

an electrical isolator positioned between the heating element and the photodiode chip.

8. The photodiode module of claim 1, wherein the heating element is part of the photodiode chip.

9. The photodiode module of claim 1, wherein the heating element is to cause a decrease in recovery time of the photodiode chip.

10. The photodiode module of claim 1, further comprising:
a thermistor positioned to detect a temperature of the heating element, the thermistor to send temperature measurements to a controller and the controller to control, by at least one hardware processor, the temperature of the heating element based on the temperature measurements.

11. The photodiode module of either claim 1 or claim 3, further comprising:
a submount located adjacent to the photodiode chip, wherein the heating element is positioned on the submount, adjacent to the photodiode chip.

12. The photodiode module of claim 11, further comprising:

a first heating element contact; and
a second heating element contact, wherein the first heating element contact and the second heating element contact are in electrical contact with the heating element and are positioned on the submount.

13. The photodiode module of claim 12, further comprising:
an electrical isolator positioned between the heating element and the photodiode chip.

14. The photodiode module of claim 1 further comprising:

a submount to support the photodiode chip; and
a fiber pigtailed package enclosing the photodiode chip and the submount.

15. The photodiode module of claim 14, wherein the heating element is positioned between a portion of the photodiode chip and a portion of the submount.

100
(PRIOR ART)

FIG. 1

200

202

224

212

222

220

218

204

214

216

208

206

210

**FIG. 2A**

250

254

258

260

256

252

**FIG. 2B**

300

**FIG. 3A**

310

**FIG. 3B**

400

410

408

412

402

404

406

414

**FIG. 4**

<u>500</u>

PROCESSOR
<u>502</u>

MEMORY
<u>504</u>

BUS
506

SECONDARY
DATA STORAGE
<u>508</u>

NETWORK
INTERFACE
<u>512</u>

I/O
<u>510</u>

*FIG. 5*

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HAMMOND SAM D.: "Improved avalanche photodiode and hybrid preamplifier for 1064-nm wavelength", PROCEEDINGS OF SPIE, vol. 1218, 1 July 1990 (1990-07-01), pages 635-643, XP093128232, ISSN: 0277-786X, DOI: 10.1117/12.18223 * abstract; figures 1,2,3,5,8,9 * * page 635 - page 637 * * page 640 - page 643 * ----- | 1-3, 5-13,15 | INV. H01L31/107 H01L31/024 H01L31/0232 H01L31/02 G02B6/42 |
| X | SUN XIAOLI ET AL: "Advanced silicon avalanche photodiodes on NASA's Global Ecosystem Dynamics Investigation (GEDI) mission", SPIE PROCEEDINGS; [PROCEEDINGS OF SPIE ISSN 0277-786X], SPIE, US, vol. 11287, 1128713, 2 March 2020 (2020-03-02), pages 1-11, XP060129130, DOI: 10.1117/12.2545203 ISBN: 978-1-5106-3673-6 * abstract; figures 1,2,5,6,7,8,10 * * subsection 2.1; page 2 - page 3 * * subsection 2.3; page 4 - page 6 * * subsection 3.1; page 7 - page 8 * ----- -/-- | 1-9, 11-15 | TECHNICAL FIELDS SEARCHED (IPC) H01L G02B |

The present search report has been drawn up for all claims

| Place of search | Date of completion of the search | Examiner |
|---|---|---|
| Berlin | 14 February 2024 | Sagol, Bülent Erol |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## EUROPEAN SEARCH REPORT

Application Number

EP 23 18 6621

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DION BRUNO ET AL: "High Performing Photodiodes For Demanding Applications", IEEE LEOS LASERS & ELECTRO-OPTICS SOCIETY NEWS, vol. 20, no. 5, October 2006 (2006-10), pages 29-32, XP093128311, * abstract; figures 1,4,5 * * page 29, left-hand column – page 32, right-hand column * | 1,3 | |
| X | US 2003/165306 A1 (IIDA KAORU [JP] ET AL) 4 September 2003 (2003-09-04) * abstract; figures 21,22,23 * * paragraphs [0034] – [0037], [0126] – [0133] * | 1,4-6,8, 10-12,14 | |
| X | US 2008/197274 A1 (HARDER JAMES ANTON [US]) 21 August 2008 (2008-08-21) * abstract; figures 1,2,3 * * paragraphs [0005] – [0007], [0013] – [0025], [0028] * | 1,3,5-7, 10-13,15 | |
| | | | TECHNICAL FIELDS SEARCHED (IPC) |
| X | CN 109 817 753 A (SOUTH WEST INST TECHNICAL PHYSICS) 28 May 2019 (2019-05-28) * abstract; figures 2,3 * * paragraphs [0001], [0002] – [0003], [0004] – [0017], [0028] – [0033] * | 1,5,6,8, 10-12,15 | |
| E | EP 4 254 017 A1 (KONINKLIJKE PHILIPS NV [NL]) 4 October 2023 (2023-10-04) * abstract; figures 1,2,4,5 * * paragraphs [0011], [0014] – [0017], [0029] – [0030], [0031] – [0033], [0037], [0041] * | 1-3,8,9 | |

The present search report has been drawn up for all claims

| Place of search | Date of completion of the search | Examiner |
|---|---|---|
| Berlin | 14 February 2024 | Sagol, Bülent Erol |

EPO FORM 1503 03.82 (P04C01)

## ANNEX TO THE EUROPEAN SEARCH REPORT
## ON EUROPEAN PATENT APPLICATION NO.

EP 23 18 6621

This annex lists the patent family members relating to the patent documents cited in the above-mentioned European search report.
The members are as contained in the European Patent Office EDP file on
The European Patent Office is in no way liable for these particulars which are merely given for the purpose of information.

14-02-2024

| Patent document cited in search report | | | Publication date | Patent family member(s) | | | Publication date |
|---|---|---|---|---|---|---|---|
| US 2003165306 | A1 | | 04-09-2003 | NONE | | | |
| US 2008197274 | A1 | | 21-08-2008 | AT | E553504 | T1 | 15-04-2012 |
| | | | | EP | 2132787 | A1 | 16-12-2009 |
| | | | | IL | 200530 | A | 30-01-2014 |
| | | | | US | 2008197274 | A1 | 21-08-2008 |
| | | | | WO | 2008103678 | A1 | 28-08-2008 |
| CN 109817753 | A | | 28-05-2019 | NONE | | | |
| EP 4254017 | A1 | | 04-10-2023 | EP | 4254017 | A1 | 04-10-2023 |
| | | | | WO | 2023186513 | A1 | 05-10-2023 |

EPO FORM P0459

For more details about this annex : see Official Journal of the European Patent Office, No. 12/82